# EUROPEAN PATENT APPLICATION

(11) **EP 1 355 063 A1**
(43) Date of publication of application: **22.10.2003**
(21) Application number: 01902654.1
(22) Date of filing: 24.01.2001
(51) Int. Cl.: F02P 3/04

(54) **IGNITION DEVICE OF INTERNAL COMBUSTION ENGINE**

(71) Applicant: Hitachi, Ltd., Chiyoda-ku, Tokyo 101-8010 (JP)
(72) Inventor: ITO, Takashi, Automotive Products Hitachi, Ltd., Hitachinaka-shi, Ibaraki 312-0062 (JP); SATO, Ryo, c/o Automotive Products Hitachi, Ltd., Hitachinaka-shi, Ibaraki 312-0062 (JP); SUGIURA, Noboru, Automotive Products Hitachi, Ltd, Hitachinaka-shi, Ibaraki 312-0062 (JP); KOBAYASHI, Ryouichi Hitachi, Ltd., Int.Prop.Group, Chiyoda-ku, Tokyo 100-8220 (JP)
(74) Representative: Beetz & Partner Patentanwälte
(86) International application number: JP0100428
(87) International publication number: WO02059478

(57) **Abstract**

A control circuit 130 carries out ON/OFF control of a primary current flowing in an ignition coil in response to an input ignition control signal. The control circuit 130 and an insulated-gate bipolar power transistor (IGBT) 110 are integrated on a monolithic silicon substrate. The control circuit 130 includes a plurality of control circuit blocks of different functions formed on the silicon substrate. The circuit functions of the control circuit blocks are enabled and disabled by changing wiring patterns.

## Description

### Technical Field

The present invention relates to an ignition device of an internal combustion engine, and more particularly to an ignition device of an internal combustion engine, which is suitable for use as one chip type including circuits integrated in an IGBT silicon chip.

### Background Art

Known examples of an ignition device of an internal combustion engine, in which circuits are integrated on a monolithic silicon substrate of an insulated-gate bipolar power transistor (IGBT), have hitherto been disclosed in, e.g., JP-A-9-177647, JP-A-8-335522 and JP-A-2000-6253. In the ignition device disclosed in JP-A-9-177647, a current limiting circuit is integrated on the monolithic silicon substrate of the IGBT. In the ignition device disclosed in JP-A-8-335522, a current limiting circuit and a thermal shutoff circuit for forcibly shutting off current supply in the event of abnormal heat generation are both integrated on the monolithic silicon substrate of the IGBT. In the ignition device disclosed in JP-A-2000-6253, a current limiting circuit and a self-shutoff circuit for inhibiting current supply when the current supply exceeds a certain time are both integrated on the monolithic silicon substrate of the IGBT.

### Disclosure of the Invention

In those conventional ignition devices of the internal combustion engines, the above-mentioned control circuits have been designed in match with respective specifications demanded by customers, and have been produced for the individual ignition devices of the internal combustion engines. Accordingly, there has been a problem that a time is required for development of each ignition device and it is impossible to timely conform to individual demands of the customers.

An object of the present invention is to provide an ignition device of an internal combustion engine, which is capable of shortening a development period.

To achieve the above object, the present invention provides an ignition device of an internal combustion engine, comprising a control circuit for carrying out ON/OFF control of a primary current flowing in an ignition coil in response to an input ignition control signal, and an insulated-gate bipolar power transistor, the control circuit being integrated on a monolithic silicon substrate of the transistor, wherein the control circuit includes a plurality of control circuit blocks of different functions formed on the silicon substrate, and the circuit functions of the control circuit blocks are enabled and disabled by changing wiring patterns.

With the constitution set forth above, a control circuit corresponding to specifications demanded by a customer can be simply obtained with change of the wiring pattern and a development period can be shortened.

### Brief Description of the Drawings

Fig. 1 is a block diagram showing a system configuration of an ignition system using an ignition device of an internal combustion engine according to one embodiment of the present invention.
Fig. 2 is a sectional view showing a configuration of a one-chip IGBT having a self-separated integrated circuit for use in the ignition device of the internal combustion engine according to one embodiment of the present invention.
Fig. 3 is a block diagram showing a basic configuration of the ignition device of the internal combustion engine according to one embodiment of the present invention.
Fig. 4 is a block diagram showing a first configuration example of the ignition device of the internal combustion engine according to one embodiment of the present invention.
Fig. 5 is a block diagram showing a second configuration example of the ignition device of the internal combustion engine according to one embodiment of the present invention.
Fig. 6 is a block diagram showing a third configuration example of the ignition device of the internal combustion engine according to one embodiment of the present invention.

### Best Mode for Carrying Out the Invention

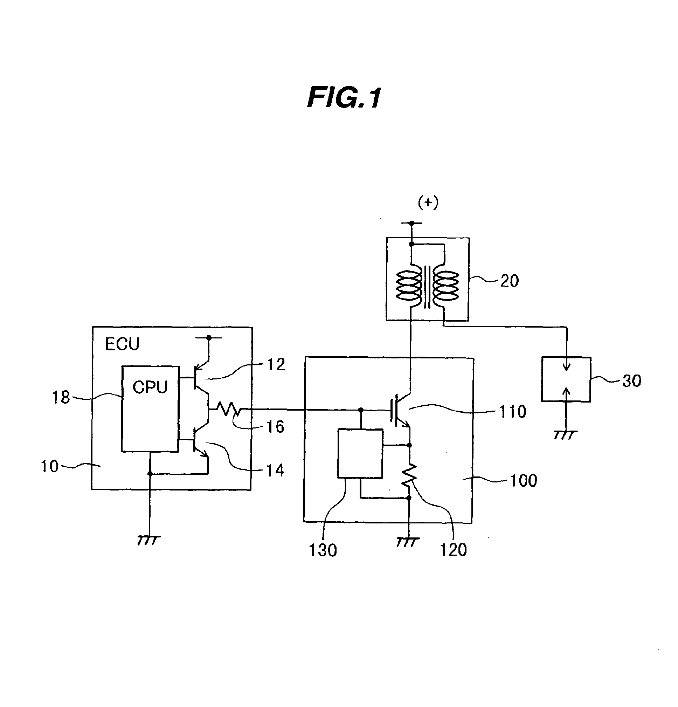

The configuration of an ignition device of an internal combustion engine according to one embodiment of the present invention will be described below with reference to Figs. 1 to 6.

A description is first made of a system configuration of an ignition system using the ignition device of the internal combustion engine according to one embodiment of the present invention with reference to Fig. 1.

Fig. 1 is a block diagram showing the system configuration of the ignition system using the ignition device of the internal combustion engine according to one embodiment of the present invention.

The ignition system according to this embodiment comprises an electronic control unit (ECU) 10 for the internal combustion engine, an ignition coil 20, an ignition plug 30, and an ignition device 100. An output stage of the ECU 10 comprises a PNP transistor 12, an NPN transistor 14, and a resistor 16. The ECU 10 turns ON/OFF the transistors 12, 14 at proper ignition timing calculated by a CPU 18, and outputs a HIGH/LOW pulse to the ignition device 100.

The ignition device 100 comprises a power transistor 110, e.g., an IGBT, a current detecting circuit 120, and a control circuit 130. The control circuit 130 is constituted as a hybrid IC and is integrated on an IGBT substrate of the power transistor 110. In the ignition device 100, when an output signal of the ECU 10 turns from a LOW to HIGH level, the power transistor 110 starts current supply, and when the output signal turns from a HIGH to LOW level, the power transistor 110 is cut off. Upon the cutoff of the power transistor 110, a voltage generates in a collector of the power transistor 110 and a high voltage corresponding to a winding ratio of the ignition coil 20 is induced on the secondary side of the ignition coil 20. The ignition plug 30 discharges with the voltage induced on the secondary side of the ignition coil 20 for igniting a fuel spray within a cylinder of the internal combustion engine.

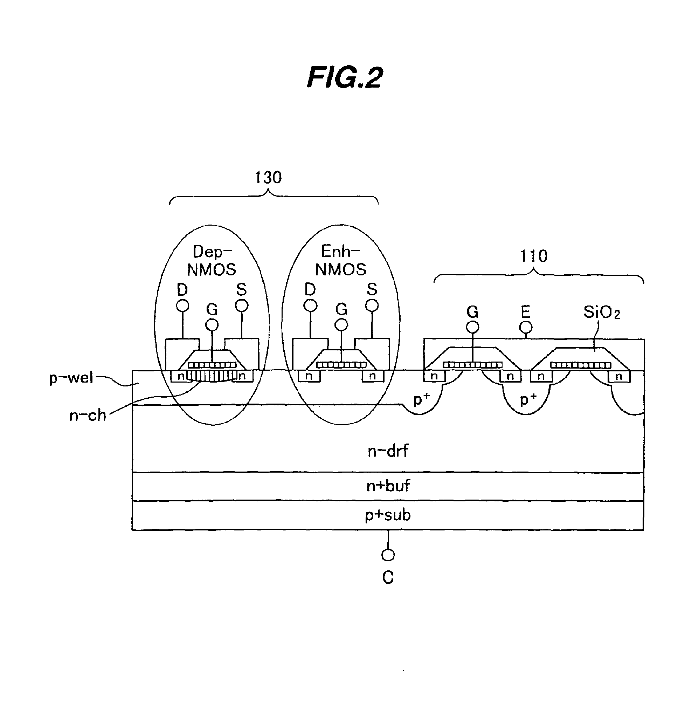

Next, a description is made of a configuration of a one-chip IGBT having a self-separated integrated circuit for use in the ignition device of the internal combustion engine according to this embodiment with reference to Fig. 2.

Fig. 2 is a sectional view showing the configuration of the one-chip IGBT having the self-separated integrated circuit for use in the ignition device of the internal combustion engine according to one embodiment of the present invention.

The IGBT power section 110 has a P+ substrate portion (P⁺sub) on the collector (C) side. After passing an n⁺ buffer layer (n⁺buf) and n⁻ drift layer (n⁻drf), a collector current flows to an emitter (E) through an N⁻MOS transistor having a plurality of N channels in its gate (G).

N⁻MOS transistors (i.e., a depression NMOS (Dep-NMOS) and an enhancement NMOS (Enh-NMOS)) constituting the control circuit 130 are formed in a p well layer (p-wel) that has been implanted in an n⁻ layer (n⁻drf). The N⁻MOS transistors constituting the control circuit 130 are of the self-separated structure in which they are isolated from the power section 110 by the p well layer (p-we1). As a result, the number of masks can be reduced and a one-chip IGBT igniter can be achieved at a lower cost.

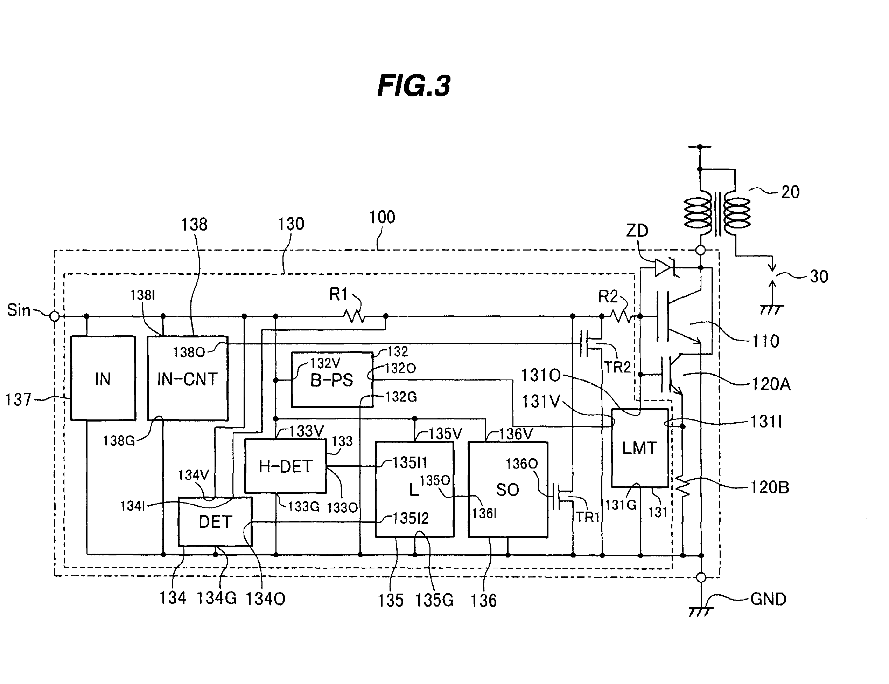

Next, a description is made of a basic configuration of the ignition device of the internal combustion engine according to this embodiment with reference to Fig. 3.

Fig. 3 is a block diagram showing the basic configuration of the ignition device of the internal combustion engine according to one embodiment of the present invention.

The ignition device 100 comprises the main IGBT 110 serving as the power transistor, the current detecting circuit 120, and the control circuit 130. The current detecting circuit 120 comprises a sensing IGBT 120A which constitutes a shunt circuit for detecting a current flowing through the main IGBT 110, and a current detecting resistor 120B connected to an emitter of the sensing IGBT 120A. The control circuit 130 is constituted by NMOS transistors having the self-separated structure and is integrated on a silicon substrate in which the main IGBT 110 and the sensing IGBT 120A are formed.

The control circuit 130 comprises a current limiting circuit 131, a reference power source circuit 132, an overheat detecting circuit 133, an abnormal current-supply detecting circuit 134, a latch circuit 135, a shutoff circuit 136, an input circuit 137, and an input voltage control circuit 138. These circuits are combined with each other to provide a plurality of control functions. The HIGH/LOW pulse outputted from the ECU 10, shown in Fig. 1, is applied to an input terminal Sin.

The current limiting circuit 131 and the reference power source circuit 132 cooperate to provide a "current limiting function". The current limiting circuit 131 detects a voltage drop across the current detecting resistor 120B connected to the emitter of the sensing IGBT 120A, and then limits a collector current when the voltage drop reaches a setting value. The current limiting circuit 131 has an input terminal 131I, an output terminal 1310, a power source terminal 131V, and a ground terminal 131G. The input terminal 131I is connected to a junction between the emitter of the sensing IGBT 120A and the current detecting resistor 120B. The output terminal 1310 is connected to a gate of the main IGBT 110. The power source terminal 131V is connected to an output terminal 1320 of the reference power source circuit 132. The ground terminal 131G is connected to a ground potential GND.

The reference power source circuit 132 creates a reference voltage for the control circuit. The reference power source circuit 132 has the output terminal 1320, a power source terminal 132V, and a ground terminal 132G. The output terminal 1320 supplies the reference voltage to the current limiting circuit 131. A power source voltage is supplied through the power source terminal 132V. The ground terminal 132G is connected to the ground potential GND.

The overheat detecting circuit 133, the latch circuit 135 and the shutoff circuit 136 cooperate to provide an "overheat protective (thermal shutoff) function". The overheat detecting circuit 133 detects abnormal overheat of the IGBT device 110. The overheat detecting circuit 133 is constituted by, e.g., a thermistor, and is disposed near the main IGBT 110. Because a resistance value of the thermistor changes depending on temperatures, the overheat detecting circuit 133 detects the temperature of the IGBT 110 and outputs an output signal upon detecting that a setting temperature is exceeded. The latch circuit 135 sets an output in response to a trigger given by the output signal of the overheat detecting circuit 133, and holds the output until an ignition signal from the ECU turns to Low. In accordance with the output of the latch circuit 135, the shutoff circuit 136 controls a transistor TR1 and then controls a gate voltage of the IGBT 110, thereby carrying out ON/OFF control of the IGBT 110.

The overheat detecting circuit 133 has an output terminal 1330, a power source terminal 133V, and a ground terminal 133G. The output terminal 1330 supplies the output signal of the circuit 133 to the latch circuit 135. The power source voltage is supplied to the power source terminal 133V. The ground terminal 133G is connected to the ground potential GND. The latch circuit 135 has input terminals 135I1. 135I2, an output terminal 1350, a power source terminal 135V, and a ground terminal 135G. The output signal from the overheat detecting circuit 133 is applied to the input terminal 13511. The output terminal 1350 supplies an output signal of the latch circuit 135 to the shutoff circuit 136. The power source voltage is supplied to the power source terminal 135V. The ground terminal 135G is connected to the ground potential GND. The shutoff circuit 136 has an input terminal 136I, an output terminal 1360, a power source terminal 136V, and a ground terminal 136G. The latched output signal from the latch circuit 135 is applied to the input terminal 136I. The output terminal 1360 supplies an output signal of the shutoff circuit 136 to a base of the transistor TR1. The power source voltage is supplied to the power source terminal 136V. The ground terminal 136G is connected to the ground potential GND.

The abnormal current-supply detecting circuit 134, the latch circuit 135 and the shutoff circuit 136 cooperate to provide an "abnormal current-supply protective (self-shutoff) function". The abnormal current-supply detecting circuit 134 determines abnormal current supply when the ON signal from the ECU 10 is a signal longer than a setting value. The latch circuit 135 sets an output in response to a trigger given by an output signal of the abnormal current-supply detecting circuit 134, and holds the output until the ignition signal from the ECU turns to Low. In accordance with the output of the latch circuit 135, the shutoff circuit 136 controls the transistor TR1 and then controls the gate voltage of the IGBT 110, thereby carrying out ON/OFF control of the IGBT 110.

The abnormal current-supply detecting circuit 134 has an input terminal 134I, an output terminal 1340, a power source terminal 134V, and a ground terminal 134G. The ON signal from the ECU 10 is applied to the input terminal 134I. The output terminal 1340 supplies the output signal of the circuit abnormal current-supply detecting 134 to the latch circuit 135. The power source voltage is supplied to the power source terminal 134V. The ground terminal 134G is connected to the ground potential GND.

The input circuit 137 provides sufficient endurance against disturbance surges and protects the various devices in the control circuit 130 from breakdown. Thus, the input circuit 137 ensures protection from the disturbance surges and prevents IGBT latch-up caused by the disturbance surges.

The input voltage control circuit 138 provides a "voltage control function". The input voltage control circuit 138 controls a transistor TR2 depending on an input signal level and then controls the gate voltage of the IGBT 110, thereby carrying out ON/OFF control of the IGBT 110. The input voltage control circuit 138 has a hysteresis characteristic. For example, the characteristic is such that when an input voltage is not smaller than V1, the IGBT 110 is turned on, and when the input voltage is not larger than V2, the IGBT 110 is cut off, V1 and V2 satisfying the relationship of V1 > V2. The input voltage control circuit 138 has an input terminal 1381, an output terminal 1380, and a ground terminal 138G. The ON signal from the ECU 10 is applied to the input terminal 1381. The input terminal 1381 serves also as a power source terminal. The output terminal 1380 supplies an output signal of the input voltage control circuit 138 to a gate of the transistor TR2. The ground terminal 138G is connected to the ground potential GND.

Additionally, a resistor R1 serves to hold the voltage of the control circuit 130 in the condition in which the gate potential of the IGBT 110 is dropped. A resistor R2 is a gate resistor functioning such that, when a zener diode ZD is operated, the gate voltage of the IGBT 110 rises with a zener current, whereupon the IGBT 110 is turned ON.

As described above, the control circuit 130 comprises the current limiting circuit 131, the reference power source circuit 132, the overheat detecting circuit 133, the abnormal current-supply detecting circuit 134, the latch circuit 135, the shutoff circuit 136, the input circuit 137, the input voltage control circuit 138, the transistors TR1, TR2, and the resistors R1, R2. Those various circuits 131, ..., 137 are each constituted by an NMOS transistor of the self-separated structure and are integrated on a silicon substrate on which the main IGBT 110 and the sensing IGBT 120A are also formed. Further, wiring for connection between the terminals of the various circuits 131, ..., 137 and wiring for connection of the various circuits to the transistors TR1, TR2 and the resistors R1, R2 (i.e., solid line portions interconnecting the various circuits and the devices shown in the drawing) are formed as aluminum wiring. After forming the various circuits and devices, the aluminum wiring is finally formed by arranging a wiring mask on a wafer substrate and then applying aluminum with vapor deposition, for example. Accordingly, the wiring can easily be modified by changing a pattern of the wiring mask.

As described above, the control circuit 130 according to this embodiment includes the various circuits corresponding to 1) the current limiting function, 2) the thermal shutoff function, 3) the self-shutoff function, and 4) the voltage control function. Then, in the condition in which the various circuits are connected to each other with the wiring as shown in Fig. 3, the above functions 1) to 4) are all enabled.

In the conventional ignition devices of the internal combustion engines, the control circuits have been designed in match with respective specifications demanded by customers, and they have been produced for use in the individual ignition devices of the internal combustion engines. Accordingly, a time has been required for development of each ignition device and it has been impossible to timely conform to individual demands of the customers. For example, specifications of one customer require a control circuit having all of the functions 1) to 4), and specifications of another customer require a control circuit having the functions 1), 2) and 4), in which the function 3) is not necessary.

In this embodiment, therefore, the control circuit 130 has the basic configuration shown in Fig. 3. Then, one or more necessary ones of the various function circuits are "disabled" depending on a customer demand so as to meet the customer demand. Note that a part of the function circuits is disabled by modifying the pattern of the wiring mask for change to the desired wiring.

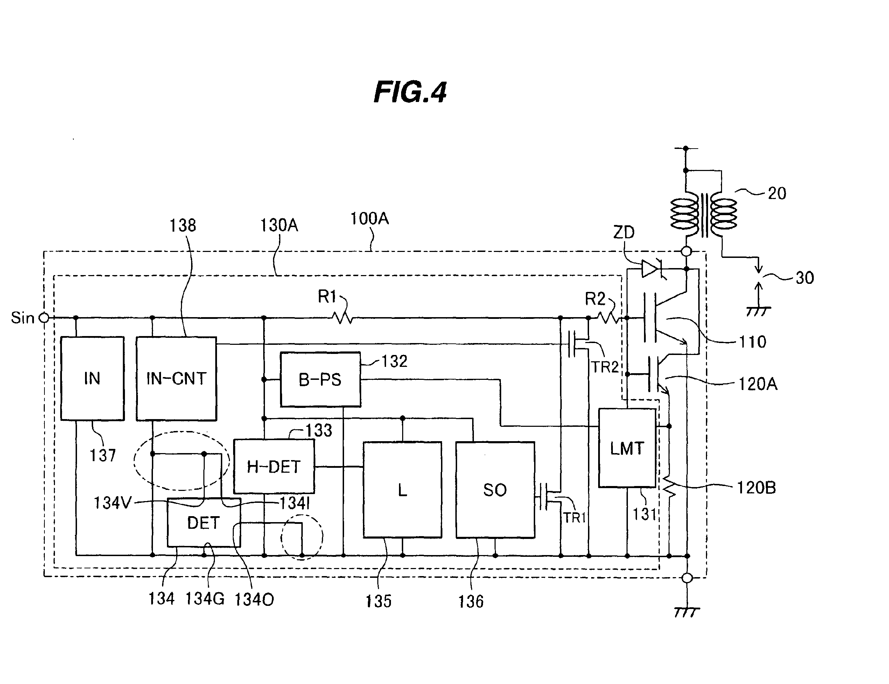

A first configuration example of the ignition device of the internal combustion engine according to this embodiment will now be described with reference to Fig. 4.

Fig. 4 is a block diagram showing the first configuration example of the ignition device of the internal combustion engine according to one embodiment of the present invention. Note that the same symbols as those in Fig. 3 denote the same components.

In a control circuit 130A according to this embodiment, the circuits corresponding to 1) the current limiting function, 2) the thermal shutoff function, and 4) the voltage control function are "enabled", but the circuit corresponding to 3) the self-shutoff function is "disabled". More specifically, as shown in Fig. 4, the control circuit 130A comprises a current limiting circuit 131, a reference power source circuit 132, an overheat detecting circuit 133, an abnormal current-supply detecting circuit 134, a latch circuit 135, a shutoff circuit 136, an input circuit 137, and an input voltage control circuit 138. Although the abnormal current-supply detecting circuit 134 corresponding to the self-shutoff function is included, it is made not to operate. In this embodiment, to "disable" the abnormal current-supply detecting circuit 134, the power source terminal 134V, the input terminal 1341, and the output terminal 1340 of the abnormal current-supply detecting circuit 134 are connected to the ground potential. With that configuration, a one-chip IGBT igniter can be obtained which has not the function of forcibly cutting off the collector current in the event of abnormal current supply. In order to connect the power source terminal 134V, the input terminal 134I, and the output terminal 1340 of the abnormal current-supply detecting circuit 134 to the ground potential, the pattern of the aluminum wiring mask is changed so as to differ from that used for forming the aluminum wiring of the control circuit 130 shown in Fig. 3. In that configuration, the various circuits integrated with the IGBT are the same as those integrated in the ignition device 100 shown in Fig. 3, while a desired control circuit is obtained only with change of the AL wiring. Accordingly, an ignition device including a control circuit corresponding to a customer demand can be easily provided. In addition, the wafer substrate itself employed in each of ignition devices is the same, and the same masks are used in the production process of the ignition devices prior to the wiring step.

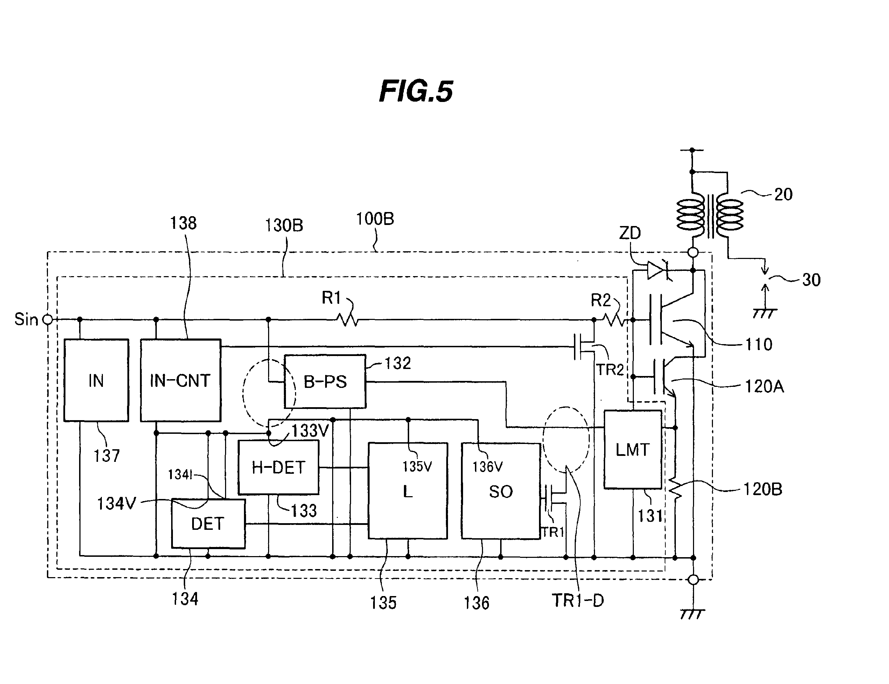

A second configuration example of the ignition device of the internal combustion engine according to this embodiment will now be described with reference to Fig. 5.

Fig. 5 is a block diagram showing the second configuration example of the ignition device of the internal combustion engine according to one embodiment of the present invention. Note that the same symbols as those in Fig. 3 denote the same components.

In a control circuit 130B according to this embodiment, the circuits corresponding to 1) the current limiting function and 4) the voltage control function are "enabled", but the circuits corresponding to 2) the thermal shutoff function and 3) the self-shutoff function are "disabled". More specifically, as in the configuration of Fig. 3, the control circuit 130B of this embodiment comprises a current limiting circuit 131, a reference power source circuit 132, an overheat detecting circuit 133, an abnormal current-supply detecting circuit 134, a latch circuit 135, a shutoff circuit 136, an input circuit 137, and an input voltage control circuit 138. Similarly to Fig. 4, although the abnormal current-supply detecting circuit 134 corresponding to the self-shutoff function is included, it is made not to operate. Further, although the overheat detecting circuit 133, the latch circuit 135, and the shutoff circuit 136 corresponding to the thermal shutoff function are included, those circuits are also made not to operate.

In this embodiment, to "disable" the abnormal current-supply detecting circuit 134, the power source terminal 134V, the input terminal 134I, and the output terminal 1340 of the abnormal current-supply detecting circuit 134 are connected to the ground potential. Also in this embodiment, to "disable" the overheat detecting circuit 133, the latch circuit 135 and the shutoff circuit 136, the power source terminal 133V of the overheat detecting circuit 133, the power source terminal 135V of the latch circuit 135, and the power source terminal 136V of the shutoff circuit 136 are all connected to the ground potential. Further, a drain TR1-D of a transistor TR1 in an output stage is made open. With that configuration, a one-chip IGBT igniter can be obtained which has not the functions of forcibly cutting off the collector current in the event of abnormal overheat and abnormal current supply. In that configuration, the various circuits integrated with the IGBT are the same as those integrated in the ignition device 100 shown in Fig. 3, while a desired control circuit is obtained only with change of the AL wiring. Accordingly, an ignition device including a control circuit corresponding to a customer demand can be easily provided. In addition, the wafer substrate itself employed in each of ignition devices is the same, and the same masks are used in the production process of the ignition devices prior to the wiring step.

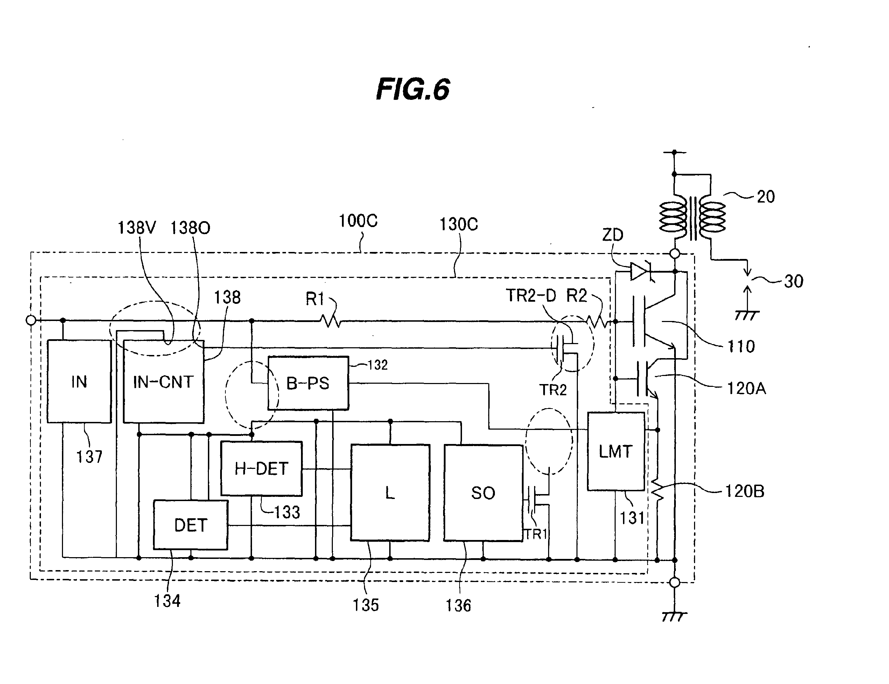

A third configuration example of the ignition device of the internal combustion engine according to this embodiment will now be described with reference to Fig. 6.

Fig. 6 is a block diagram showing the third configuration example of the ignition device of the internal combustion engine according to one embodiment of the present invention. Note that the same symbols as those in Fig. 3 denote the same components.

In a control circuit 130C according to this embodiment, the circuits corresponding to 1) the current limiting function are "enabled", but the circuits corresponding to 2) the thermal shutoff function, 3) the self-shutoff function, and 4) the voltage control function are "disabled". More specifically, as in the configuration of Fig. 3, the control circuit 130C of this embodiment comprises a current limiting circuit 131, a reference power source circuit 132, an overheat detecting circuit 133, an abnormal current-supply detecting circuit 134, a latch circuit 135, a shutoff circuit 136, an input circuit 137, and an input voltage control circuit 138. Similarly to Fig. 5, although the abnormal current-supply detecting circuit 134 corresponding to the self-shutoff function and the overheat detecting circuit 133, the latch circuit 135 and the shutoff circuit 136 corresponding to the thermal shutoff function are included, those circuits are made not to operate. Further, although the input voltage control circuit 138 corresponding to the voltage control function is included, it is also made not to operate.

The abnormal current-supply detecting circuit 134, the overheat detecting circuit 133, the latch circuit 135, and the shutoff circuit 136 are "disabled" with the same circuit configuration as that shown in Fig. 5. Further in this embodiment, to "disable" the input voltage control circuit 138, the power source terminal 138V of the input voltage control circuit 138 is connected to the ground potential, and a drain TR2-D of a transistor TR2 in an output stage is made open. With that configuration, a one-chip IGBT igniter can be obtained which has not the functions of forcibly cutting off the collector current in the event of abnormal overheat, abnormal current supply, and an abnormal input voltage. In that configuration, the various circuits integrated with the IGBT are the same as those integrated in the ignition device 100 shown in Fig. 3, while a desired control circuit is obtained only with change of the AL wiring. Accordingly, an ignition device including a control circuit corresponding to a customer demand can be easily provided. In addition, the wafer substrate itself employed in each of ignition devices is the same, and the same masks are used in the production process of the ignition devices prior to the wiring step.

The above description has been made of A) the example in which only the circuits corresponding to 3) the self-shutoff function are disabled (Fig. 4), B) the example in which the circuits corresponding to 2) the thermal shutoff function and 3) the self-shutoff function are disabled (Fig. 5), and C) the example in which the circuits corresponding to 2) the thermal shutoff function, 3) the self-shutoff function, and 4) the voltage control function are disabled (Fig. 6). However, the control circuit can also be obtained in any of D) the configuration in which the circuits corresponding to 4) the voltage control function are disabled, E) the configuration in which the circuits corresponding to 2) the thermal shutoff function are disabled, F) the configuration in which the circuits corresponding to 2) the thermal shutoff function and 4) the voltage control function are disabled, and G) the configuration in which the circuits corresponding to 3) the self-shutoff function and 4) the voltage control function are disabled. In those cases, for each of the circuits to be disabled, the power source terminal is connected to the ground potential, and the output terminal is connected to the ground potential or it is made open. If there is an input terminal, the input terminal is also connected to the ground potential.

With this embodiment, as described above, the control circuit includes the various circuits corresponding to 1) the current limiting function, 2) the thermal shutoff function, 3) the self-shutoff function, and 4) the voltage control function. Then, an ignition device including a control circuit corresponding to a customer demand can be easily provided by "enabling" one part of those functions and "disabling" the other part of those functions. Also, the circuits can be each easily disabled because it is just required to change aluminum wiring. Accordingly, a period required for development of the ignition device can be shortened.

Further, since a merit in cutting costs is realized with the use of a silicon substrate in common, an inexpensive ignition device can be speedily provided.

### Industrial Applicability

According to the present invention, it is possible to shorten a development period of an ignition device of an internal combustion engine.

## Claims

1. An ignition device of an internal combustion engine, comprising a control circuit for carrying out ON/OFF control of a primary current flowing in an ignition coil in response to an input ignition control signal, and an insulated-gate bipolar power transistor, said control circuit being integrated on a monolithic silicon substrate of said transistor,
wherein said control circuit includes a plurality of control circuit blocks of different functions formed on said silicon substrate, and
the circuit functions of said control circuit blocks are enabled and disabled by changing wiring patterns.

2. An ignition device of an internal combustion engine according to Claim 1, wherein said control circuit is constituted by self-separated NMOS transistors, which are isolated from said transistor by a P well layer implanted in said silicon substrate and are formed in said P well layer.

3. An ignition device of an internal combustion engine according to Claim 1, wherein a wiring pattern of said control circuit is formed with aluminum vapor deposition, and the circuit functions are enabled and disabled by changing the wiring pattern in a process of forming the pattern.

4. An ignition device of an internal combustion engine according to Claim 1, wherein said control circuit block is disabled by connecting an input terminal and a power source terminal of said control circuit block to a ground potential while an output terminal is connected to the ground potential or an output stage is made open.
